# EUROPEAN PATENT SPECIFICATION

(11) **EP 0 462 752 B1**
(45) Date of publication and mention of the grant of the patent: **06.12.1995**
(21) Application number: 91305323.7
(22) Date of filing: 12.06.1991
(51) Int. Cl.: H04N 5/10

(54) **Horizontal synchronizing signal separator**
Horizontal-Synchronsignal-Trennschaltung
Séparateur de signal de synchronisation horizontale

(30) Priority: 21.06.1990 JP 163325/90
(43) Date of publication of application: 27.12.1991
(73) Proprietor: MATSUSHITA ELECTRIC INDUSTRIAL CO., LTD., Kadoma-shi, Osaka-fu, 571 (JP)
(72) Inventor: Kawamoto, Sigeharu, Yokohama-shi (JP)
(74) Representative: Votier, Sidney David

(56) References cited:
- GB-A- 2 086 177
- PATENT ABSTRACTS OF JAPAN vol. 14, no. 222 (E-926)(4165) 10 May 1990& JP-A-2 055 474

## Description

### BACKGROUND OF THE INVENTION

### FIELD OF THE INVENTION

The present invention generally relates to a horizontal synchronizing signal separator which separates a horizontal synchronizing signal from a video composite synchronizing pulse signal for use in video signal processing.

### DESCRIPTION OF THE PRIOR ART

In the transmission of a video signal based on a standard television system, a video synchronizing pulse signal comprising a horizontal synchronizing pulse signal, a vertical synchronizing signal and an equalizing pulse signal is inserted in the video signal during its flyback blanking time; while, on the side of video signal reception, the video synchronizing pulse signal is extracted from the received video signal and the horizontal and vertical synchronizing signals are separated from the video synchronizing pulse signal as the processing of the video signal.

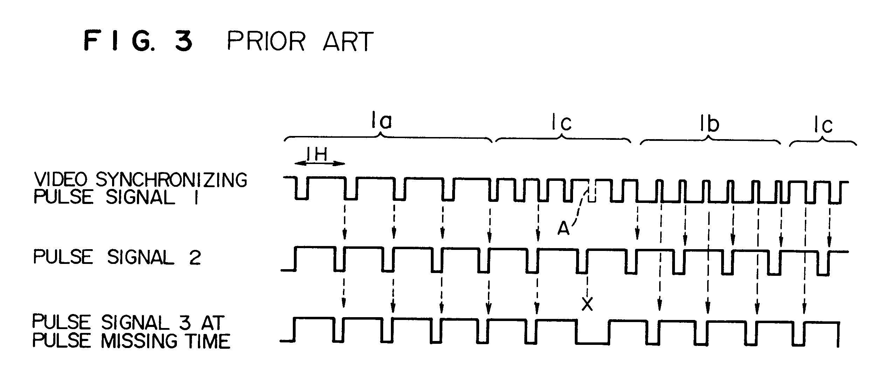

Explanation will be made as to the separating operation of a horizontal synchronizing signal from a video synchronizing pulse signal in a prior art horizontal synchronizing signal separator, by referring to Fig. 3.

In Fig. 3, reference numeral 1 denotes a video synchronizing pulse signal which comprises a horizontal synchronizing pulse signal 1a, an equalizing pulse signal 1c, a vertical synchronizing pulse signal 1b, the equalizing pulse signal 1c,..., sequentially arranged from the left side in the drawing. Each of these signals 1a, 1c, 1b are assumed to have a train of 6 consecutive pulses, though partly omitted in the drawing. Reference numeral 2 denotes a pulse signal which is generated from, e.g., a non-retriggerable monostable multivibrator for the purpose of obtaining the horizontal synchronizing signal from the video synchronizing pulse signal 1, while reference numeral 3 denotes a pulse signal which is generated from the monostable multivibrator when there is a missing pulse in the video synchronizing pulse signal 1.

In the case where such a video synchronizing pulse signal 1 based on the standard television system as shown in Fig. 3 is employed, generally speaking, if the horizontal synchronization has a period of H, then the horizontal synchronizing pulse signal 1a has a period of H and the vertical synchronizing pulse signal 1b and the equalizing pulse signal 1c have respectively a period of H/2.

Thus, when it is desired to separate a horizontal synchronizing signal from the video synchronizing pulse signal 1, such a pulse signal 2 that rises when a front edge in each period H of the video synchronizing pulse signal 1 is detected and falls in a time shorter than the period H of the horizontal synchronizing signal is generated from a pulse signal generating means such as a monostable multivibrator.

The rising edges of the pulse signal 2 are handled as the horizontal synchronizing signal obtained through separation from the video synchronizing pulse signal 1.

With the aforementioned prior art horizontal synchronizing signal separator, however, in the case where the video synchronizing pulse signal 1 is obtained from a special reproduction image signal of a video tape recorder, if a pulse is missing in the equalizing pulse signal 1c as shown by an arrow A in Fig. 3, then the pulse signal obtained through detection of the front edge of the video synchronizing pulse signal 1 corresponds to the pulse signal 3 having a period shifted by a phase of H/2 in its part subsequent to the missing pulse position of the equalizing pulse signal 1c.

The pulse signal 3 once subjected to such a phase shift cannot be returned to its original normal phase until the next front edge of the horizontal synchronizing pulse signal la is detected. Therefore, such a problem occurs that the horizontal synchronization remains disturbed during a time duration between the missing pulse position of the equalizing pulse signal 1c and the detection of the next front edge of the horizontal synchronizing pulse signal 1a.

It would therefore be desirable to provide a horizontal synchronizing signal separator which can solve the above problem in the prior art and which can correct a pulse missing in a video synchronizing pulse signal to minimize a phase shift in horizontal synchronization, thereby realizing stable separation of a horizontal synchronizing signal.

In accordance with the present invention, there is provided a horizontal synchronizing signal separator as defined in claim 1.

With such an arrangement, since a pulse missing in the video synchronizing pulse signal is corrected to minimize a phase shift in the horizontal synchronization, the horizontal synchronizing signal can be separated stably.

It would further be desirable to provided a horizontal synchronizing signal separator which can prevent the phenomenon whereby, when correction is made over consecutive missing pulses in a video synchronizing pulse signal, phase shifts in horizontal synchronization are accumulated, it becoming impossible to detect a front edge in the normal video synchronizing pulse signal any longer.

To overcome this problem, a second timer means is preferably provided, having the features defined in claim 2.

### BRIEF DESCRIPTION OF THE DRAWINGS

Fig. 1 is a circuit diagram showing a schematic arrangement of a horizontal synchronizing signal separator in accordance with an embodiment of the present invention;
Figs. 2A and 2B are timing charts of signals appearing at various parts in the horizontal synchronizing signal separator of Fig. 1 for explaining the operation thereof; and
Fig. 3 is a timing chart of signals appearing at various parts in a prior art horizontal synchronizing signal separator for explaining the operation thereof.

### DESCRIPTION OF THE PREFERRED EMBODIMENTS

An embodiment of the present invention will be explained with reference to the accompanying drawings.

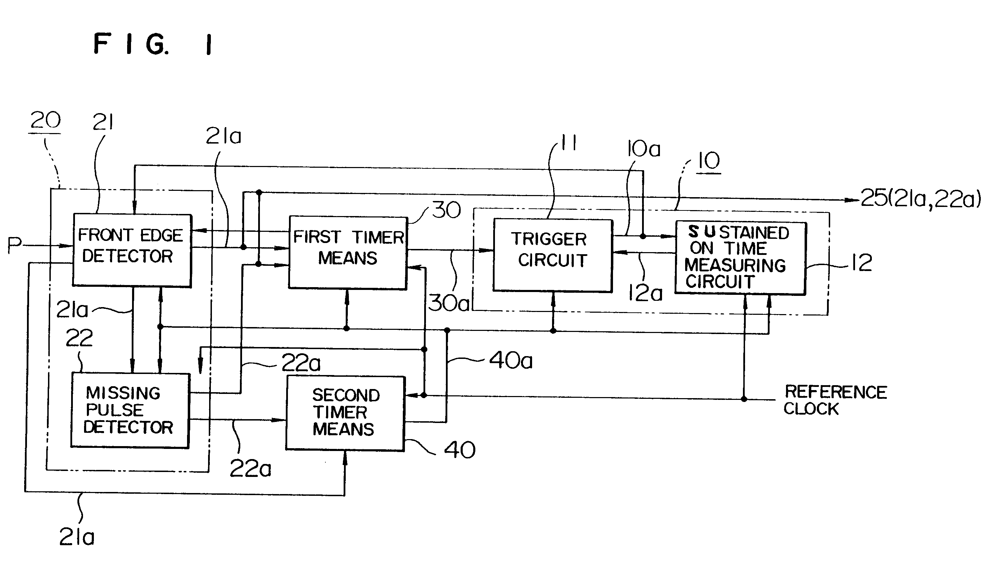

Referring first to Fig. 1, there is shown a circuit diagram showing schematic arrangement of a horizontal synchronizing signal separator in accordance with an embodiment of the present invention. The horizontal synchronizing signal separator of the drawing includes an activation signal generating means 10 which comprises such a trigger circuit 11 as, for example, a flip-flop and a sustained-time measurement circuit 12 for measuring a time of about 0.4H. The activation signal generator 10 generates, when triggered, an activation signal 10a for a predetermined sustaining time (about 4/10 of a period H of a horizontal synchronizing signal, i.e., about 0.4H, in the present embodiment).

The trigger circuit 11, when externally triggered to be shifted from its state "0" to "1", generates the activation signal 10a. Meanwhile, the sustained-time measurement circuit 12, when receiving the activation signal 10a from the trigger circuit 11, starts measuring a time duration of about 0.4H and when completing the measurement of the time-out duration, outputs an inversion signal 12a to the trigger circuit 11 to shift the state of the trigger circuit 11 from "1" to "0" and to stop outputting of the activation signal 10a therefrom.

The activation signal generating means 10, when externally triggered in this manner, outputs the activation signal 10a having a sustained time of about 0.4H.

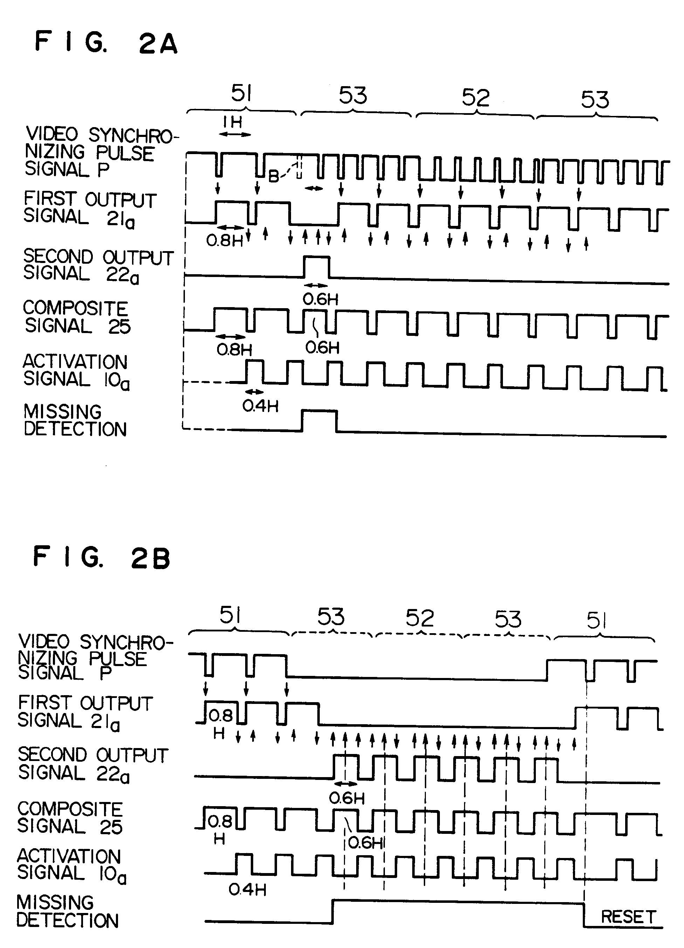

The horizontal synchronizing signal separator also includes a front edge detection means 20 which receives the aforementioned activation signal 10a and such a video synchronization pulse signal P as shown in Fig. 2A. More specifically, the front edge detection means 20 comprises a front edge detecting circuit 21 for detecting a front edge in the video synchronization pulse signal P to generate a first output signal 21a and a front-edge missing detection circuit 22 for generating a second output signal 22a when failing to detect the front edge.

In more detail, the front edge detector 21, when detecting the front edge of the video synchronization pulse signal P during reception of the activation signal 10a, outputs the first output signal 21a. Meanwhile, the front-edge missing detection circuit 22, when receiving the first output signal 21a from the front edge detection circuit 21 during the time counting operation of 0.4H based on the reception of the activation signal 10a, resets the time counting operation. When failing to receive the first output signal 21a from the front-edge detection circuit 21 during the time counting operation, the front-edge missing detection circuit 22 outputs the second output signal 22a.

In this way, the front-edge detecting means 20 generates the first output signal 21a when detecting the front edge of the video synchronization pulse signal P during reception of the activation signal 10a; whereas, the detecting means 20 generates the second output signal 22a when the reception period of the activation signal 10a expires without any detection of the front edge of the video synchronization pulse signal P.

The horizontal synchronizing signal separator further includes a first timer means 30 which receives the first and second output signals 21a and 22a from the front-edge detection means 20. The first timer means 30, when receiving either one of the first and second output signals 21a and 22a to be triggered and when expiring its time-out duration, outputs a trigger signal 30a to the activation signal generating means 10 to trigger the same.

The first timer means 30 is set to have two different time-out durations. That is, the first timer means 30, when triggered by the first output signal 21a, is set to have one of the two time-out durations; while, the timer 30 is set to have the other when triggered by the second output signal 22a. In the present embodiment, more specifically, the first time-out duration is set to be about 0.8H when the first timer means 30 is triggered by the first output signal 21a; while the second time-out duration is set to be about 0.6H when the timer 30 is triggered by the second output signal 22a.

A second timer means 40 receives the first and second output signals 21a and 22a from the front-edge detection means 20. More specifically, the second timer 40, when receiving the second output signal 22a, starts its time counting operation; while the second timer 40, when receiving the first output signal 21a, stops its time counting operation.

Further, the second timer means 40, when measuring a predetermined time after the reception of the second output signal 22a, outputs a reset signal 40a to the activation signal generator 10, the front-edge detector 20 and the first timer 30 to reset their time counting functions.

Also externally supplied to the sustained-time measurement circuit 12, front-edge missing detection circuit 22, first timer means 30 and second timer means 40 is a reference clock signal to perform their time counting operation on the basis of the reference clock.

The operation of the horizontal synchronizing signal separator of the present embodiment having such an arrangement as mentioned above will next be explained by timing charts shown in Figs. 2A and 2B. In the drawings, reference numerals 51, 52 and 53 denote horizontal synchronizing, vertical synchronizing and equalizing pulses in the video synchronizing pulse signal P, respectively.

First, the activation signal generation means 10 is triggered by the trigger signal 30a received from the first timer means 30 to generate such an activation signal 10a having a sustaining time of about 0.4H as shown in Fig. 2A that is then sent to the front edge detecting means 20.

The front edge detector 20, when receiving the activation signal 10a from the activation signal generator 10, detects a front end in such a video synchronizing pulse signal P as shown in Fig. 2A during the reception of the activation signal 10a having a sustaining time of about 0.4H.

The front edge detector 20, when detecting the front edge of the video synchronizing pulse signal P during the reception of the activation signal 10a, generates such a first output signal 21a as shown in Fig. 2 A that is then sent to the first timer means 30.

The first timer means 30, when receiving the first output signal 21a, outputs the trigger signal 30a to the activation signal generator 10 after elapse of the first time-out duration, i.e., a time-out duration of about 0.8H.

The above operation is repeated so that the horizontal synchronizing signal is separated from the input video synchronizing pulse signal P.

If there is such a missing pulse (which would be supposed to originally exist) as shown by a broken line in Fig. 2A in the equalizing pulses 53 of the video synchronizing pulse signal P, then the front edge detection means 20 cannot detect the front edge of the pulse B in the video synchronizing pulse signal P during such a sustaining duration of the activation signal 10a as shown by arrows B.

Thus, the front edge detection means 20 outputs the second output signal 22a to the timer means 30 as delayed by about 0.2H after passage of the sustaining time duration of the activation signal 10a. The timer means 30, when receiving the second output signal 22a, outputs the trigger signal 30a to the activation signal generation means 10 after passage of the second time-out duration, i.e., about 0.6H.

Accordingly, even when there is a missing pulse in the equalizing pulse signal 53, the separating operation of the horizontal synchronizing signal from the input video synchronizing pulse signal P is carried out at such timing as shifted only by a phase of about 0.2H with respect to the normal horizontal synchronization.

Further, a time period between the termination of the sustaining time duration of the activation signal 10a at the time of missing of the equalizing pulse 53 and the output of the trigger signal 30a to the activation signal generation means 10 corresponds to about 0.8H that is nearly equal to the output period of the normal activation signal 10a, so that the next front edge of the video synchronizing pulse signal P can be detected.

In the case where there are continual missing pulses in the equalizing pulse signal 53 of the video synchronizing pulse signal P as shown in Fig. 2B, the front edge detection means 20 outputs the second output signal 22a as delayed by about 0.2H after passage of the sustaining duration of the activation signal 10a, after which substantially the same operation as mentioned above is repeated.

The time period between the termination of the sustaining time duration of the activation signal 10a at the time of missing of the equalizing pulse 53 and the output of the trigger signal 30a to the activation signal generation means 10 nearly coincides with the output period of the normal activation signal 10a. However, there occur a certain number of continual missing pulses in the equalizing pulse signal 53, an error between the above mutual periods is accumulated, which results in that it becomes impossible to detect the next normal front edge at a probability of about 60%.

To avoid such a disadvantage, there is provided such a second timer means that receives the first output signal 21a from the front edge detecting circuit 21 and the second output signal 22a from the trigger circuit 22, so that the second timer starts its time counting operation when receiving the second output signal 22a while the second timer stops the time counting operation when receiving the first output signal 21a during the time counting operation.

When the second timer means comletes a predetermined length of time counting operation after the reception of the second output signal 22a, that is, when a predetermined number of missing pulses continuously takes place in the equalizing pulse signal 53 of the video synchronizing pulse signal P, the second timer means outputs the reset signal 40a to the activation signal generator 10, front edge detector 20 and first timer 30 to return these components in their initial state to thereby prevent the missing pulses from adversely affecting the next front edge detection.

In addition, the second timer means 40, at the time of outputting the reset signal 40a, resets its time counting operation, which has been so far done, to return its own to its initial state.

As has been explained in the foregoing, in the horizontal synchronizing separator of the present embodiment, the front edge detecting means 20 outputs the first output signal 21a at the time of detecting a front edge and outputs the second output signal 22a in the case of a missing pulse or pulses in the equalizing pulse signal 53 and a composite signal 25 of these two output signals 21a and 22a is output from the horizontal synchronizing separator as a signal for extraction of a horizontal synchronizing signal.

The horizontal synchronizing signal is separated from the video synchronizing pulse signal P on the basis of pulse rising edges of the composite signal 25, i.e., pulse rising edges of the first and second output signals 21a and 22a.

## Claims

1. A horizontal synchronizing signal separator comprising:
activation signal generating means (10) for generating, when subjected to a triggering operation, an activation signal (10a) having a predetermined continuous ON time period:
front edge detecting means (20) for receiving said activation signal (10a) and a video synchronizing pulse signal (P) containing a horizontal synchronizing pulse signal and for outputting a first output pulse (21a) upon detecting a front edge of said video synchronizing pulse signal (P) within said ON time period of said activation signal (10a) and outputting a second output pulse (22a) when no front edge of said video synchronizing pulse signal (P) is detected within said ON time period of said activation signal (10a);
first timer means (30) for triggering said activation signal generating means (10) a first predetermined time after receiving said first output pulse (21a) of said front edge detecting means (20) and a second predetermined time after receiving said second output pulse (22a) of said front edge detecting means (20), said first predetermined time being longer than said second predetermined time; and
means for combining said first and second output pulses (21a, 22a) of said front edge detecting means (20) to generate a combined signal (25) and output said combined signal (25) as the horizontal synchronizing pulse signal.

2. A horizontal synchronizing signal separator according to claim 1, further comprising:
second timer means (40) for starting a time counting operation when receiving said second output pulse (22a) of said front edge detecting means (20) and stopping the time counting operation when receiving said first output pulse (21a) of said front edge detecting means (20) within the time counting operation and for outputting, after a predetermined time, a reset signal (40a) to said activation signal generating means (10), said front edge detecting means (20) and said first timer means (30).

3. A horizontal synchronizing signal separator according to claim 1 or claim 2, wherein said activation signal generating means (10) includes a flip-flop (11) and a sustained ON time measuring circuit (12) for starting to measure a time-out period of 0.4H when triggered by said first timer means (30), where H is the normal period of the horizontal synchronizing signals, and resetting said flip-flop when said time-out period expires.

4. A horizontal synchronizing signal separator according to claim 1 or claim 2, wherein said first predetermined time corresponds to 0.8H and said second predetermined period corresponds to 0.6H, where H is the normal period of the horizontal synchronizing signals.

## Patentansprüche

1. Horizontalsynchronisiersignal-Trenneinrichtung mit:
einer Aktivierungssignal-Erzeugungseinrichtung (10) zum Erzeugen eines Aktivierungssignals (10a) mit einer vorgegebenen kontinuierlichen Einschaltzeitperiode, wenn sie einem Triggerbetrieb unterzogen wird;
einer Erfassungseinrichtung (20) für eine vordere Flanke zum Empfangen des Aktivierungssignals (10a) und eines ein Horizontalsynchronisier-Impulssignal enthaltenden Videosynchronisier-Impulssignals (P) sowie zum Ausgeben eines ersten Ausgabeimpulses (21a) nach Erfassen einer vorderen Flanke des Videosynchronisier-Impulssignals (P) innerhalb der Einschaltzeitperiode des Aktivierungssignals (10a) und zum Ausgeben eines zweiten Ausgabeimpulses (22a), wenn keine vordere Flanke des Videosynchronisier-Impulssignals (P) innerhalb der Einschaltzeitperiode des Aktivierungssignals (10a) erfaßt wird;
einer ersten Zeitgebereinrichtung (30) zum Triggern der Aktivierungssignal-Erzeugungseinrichtung (10) nach Ablauf einer ersten vorgegebenen Zeit nach Empfangen des ersten Ausgabeimpulses (21a) der Erfassungseinrichtung (20) für die vordere Flanke sowie nach Ablauf einer zweiten vorgegebenen Zeit nach Empfangen des zweiten Ausgabeimpulses (22a) der Erfassungseinrichtung (20) für die vordere Flanke, wobei die erste vorgegebene Zeit länger ist als die zweite vorgegebene Zeit; und
einer Einrichtung zum Kombinieren des ersten Ausgabeimpulses (21a) und des zweiten Ausgabeimpulses (22a) der Erfassungseinrichtung (20) für die vordere Flanke zum Erzeugen eines kombinierten Signals (25) sowie zum Ausgeben des kombinierten Signals (25) als Horizontalsynchronisier-Impulssignal.

2. Horizontalsynchronisiersignal-Trenneinrichtung nach Anspruch 1, ferner umfassend:
eine zweite Zeitgebereinrichtung (40) zum Starten eines Zeitzählbetriebes bei Empfang des zweiten Ausgabeimpulses (22a) der Erfassungseinrichtung (20) für die vordere Flanke und zum Stoppen des Zeitzählbetriebes bei Empfang des ersten Ausgabeimpulses (21a) der Erfassungseinrichtung (20) für die vordere Flanke innerhalb des Zeitzählbetriebes und zum Ausgeben eines Rücksetzsignals (40a) an die Aktivierungssignal-Erzeugungseinrichtung (10), die Erfassungseinrichtung (20) für die vordere Flanke und die erste Zeitgebereinrichtung (30) nach einer vorgegebenen Zeit.

3. Horizontalsynchronisiersignal-Trenneinrichtung nach Anspruch 1 oder Anspruch 2, bei der die Aktivierungssignal-Erzeugungseinrichtung (10) enthält ein Flip-Flop (11) und eine Schaltung (12) zum Messen einer andauernden Einschaltzeit zum Starten einer Messung einer Auszeitperiode von 0,4 H, wenn sie mit der ersten Zeitgebereinrichtung (30) getriggert wird, wobei H die normale Periode der Horizontalsynchronisiersignale ist, sowie zum Rückstellen des Flip-Flops, wenn die Auszeitperiode abläuft.

4. Horizontalsynchronisiersignal-Trenneinrichtung nach Anspruch 1 oder 2, bei der die erste vorgegebene Zeit 0,8 H entspricht und die zweite vorgegebene Periode (richtig: Zeit) 0,6 H entspricht, wobei H die normale Periode der Horizontalsynchronisiersignale ist.

## Revendications

1. Séparateur de signal de synchronisation horizontale, comprenant :
des moyens générateurs de signal d'activation (10) pour générer, une fois soumis à une opération de déclenchement, un signal d'activation (10a) ayant une période de temps de marche continue prédéterminée ;
des moyens de détection de flanc avant (20) pour recevoir ledit signal d'activation (10a) et un signal pulsé de synchronisation vidéo (P) contenant une signal pulsé de synchronisation horizontale et pour délivrer une première impulsion de sortie (21a) en cas de détection d'un flanc avant dudit signal pulsé de synchronisation vidéo (P) pendant ladite période de temps de marche dudit signal d'activation (10a) et délivrer une deuxième impulsion de sortie (22a) lorsque aucun flanc avant dudit signal pulsé de synchronisation vidéo (P) n'est détecté pendant ladite période de temps de marche dudit signal d'activation (10a) ;
des premiers moyens de temporisation (30) pour déclencher lesdits moyens générateurs de signal d'activation (10) au bout d'une première période prédéterminée après la réception de ladite première impulsion de sortie (21a) desdits moyens de détection de flanc avant (20) et au bout d'une deuxième période prédéterminée après la réception de ladite deuxième impulsion de sortie (22a) desdits moyens de détection de flanc avant (20), ladite première période prédéterminée étant plus longue que ladite deuxième période prédéterminée ; et
des moyens pour combiner lesdites première et deuxième impulsions de sortie (21a, 22a) desdits moyens de détection de flanc avant (20) pour générer un signal combiné (25) et délivrer ledit signal combiné (25) en tant que signal pulsé de synchronisation horizontale.

2. Séparateur de signal de synchronisation horizontale selon la revendication 1, comprenant de plus :
des deuxièmes moyens de temporisation (40) pour démarrer une opération de décompte de temps à la réception de ladite deuxième impulsion de sortie (22a) desdits moyens de détection de flanc avant (20) et arrêter l'opération de décompte de temps à la réception de ladite première impulsion de sortie (21a) desdits moyens de détection de flanc avant (20) pendant l'opération de décompte de temps, et pour délivrer, après une période prédéterminée, un signal de remise à zéro (40a) auxdits moyens générateurs de signal d'activation (10), auxdits moyens de détection de flanc avant (20) et auxdits premiers moyens de temporisation (30).

3. Séparateur de signal de synchronisation horizontale selon la revendication 1 ou 2, dans lequel lesdits moyens générateurs de signal d'activation (10) comprennent une bascule flip-flop (11) et un circuit de mesure de temps de marche continue (12) pour démarrer la mesure d'une période de temps mort de 0,4H après déclenchement par lesdits premiers moyens de temporisation (30), où H est la période normale des signaux de synchronisation horizontale, et remettre à zéro ladite bascule flip-flop lorsque ladite période de temps mort expire.

4. Séparateur de signal de synchronisation horizontale selon la revendication 1 ou 2, dans lequel ladite première période prédéterminée correspond à 0,8H et ladite deuxième période prédéterminée correspond à 0,6H où H est la période normale des signaux de synchronisation horizontale.
